# EUROPÄISCHE PATENTSCHRIFT

(11) **EP 0 418 419 B1**
(45) Veröffentlichungstag und Bekanntmachung des Hinweises auf die Patenterteilung: **14.12.1994**
(21) Anmeldenummer: 89117551.5
(22) Anmeldetag: 22.09.1989
(51) Int. Cl.: H03K 5/15

(54) **Zweiphasentaktgenerator**
Two-phase clock generator
Générateur à deux phases

(43) Veröffentlichungstag der Anmeldung: 27.03.1991
(73) Patentinhaber: Deutsche ITT Industries GmbH, 79108 Freiburg (DE)
(72) Erfinder: Ullrich, Manfred, Fritz Dipl.-Ing. (FH), D-7819 Denzlingen (DE)

(56) Entgegenhaltungen:
- EP-A- 0 262 412
- PATENT ABSTRACTS OF JAPAN, Band 13, Nr. 359 (E-804)[3707], 10. August 1989;& JP-A-1 117 516 (NEC CORP.) 10-05-1989

## Beschreibung

Bei der digitalen Signalverarbeitung ist häufig zur Steuerung der einzelnen Funktionseinheiten ein nichtüberlappender Zweiphasentakt erforderlich, der aus einem ersten Takt und einem nichtüberlappenden zweiten Takt besteht. Die Erzeugung dieser beiden Takte erfolgt in einem Zweiphasentaktgenerator aus einem unipolaren Eingangstakt, der in der Regel ein Puls/Pausenverhältnis von eins zu eins aufweist. Bei hohen Signalverarbeitungsgeschwindigkeiten ist die Herleitung der beiden nichtüberlappenden Takte aus einem höherfrequenten Takt durch logische Verknüpfung der High- bzw. Low-Zustände nicht mehr möglich. Durch Ausnutzung der Laufzeiten von Gattern lassen sich indessen auch bei hohen Frequenzen nichtüberlappende Takte erzeugen. Typisch für diese bekannten Schaltungsanordnungen ist, daß vom jeweiligen Taktausgang das Taktsignal auf jeweils ein Verknüpfungsgatter zurückgeführt wird, das im ersten und im zweiten Signalpfad liegt. Die Taktrückführung erfolgt dabei überkreuz jeweils auf den anderen Signalpfad.

Durch diese Signalrückführung wird erreicht, daß immer eines der beiden Verknüpfungsgatter erst dann seinen Zustand ändert, wenn das Ausgangssignal im anderen Signalpfad seinen neuen Zustand eingenommen hat. Damit ist die Nichtüberlappung gewährleistet. Die Dauer der Nichtüberlappungszeit wird zumindest durch die Laufzeiten der Gatter in dem jeweiligen Signalpfad bestimmt, der in der Regel aus dem Verknüpfungsgatter, mehreren Inverterstufen und dem Ausgangspuffer besteht. Die beiden Verknüpfungsgatter sind eingangsseitig ferner mit einem gegenphasigen Signal gespeist, das mittels weiterer Inverterstufen aus dem Eingangstakt gebildet ist.

Ein Nachteil derartiger Zweiphasentaktgeneratoren ist, daß bei hohen Taktfrequenzen der Nichtüberlappungsteil relativ groß ist und daß die aktive Taktphase daher zeitlich unnötig begrenzt wird. Andererseits läßt sich die Anzahl der Gatter nicht beliebig verkleinern, weil bei den verwendeten NOR- bzw. NAND-Verknüpfungsgattern die Phasenlage des zurückgeführten Taktes beachtet werden muß, wodurch die Mindestanzahl der Gatter, in der Regel handelt es sich dabei um Inverter, vorgegeben ist.

Es ist daher Aufgabe der in den Ansprüchen gekennzeichneten Erfindung, einen Zweiphasentaktgenerator für zwei nichtüberlappende Takte anzugeben, deren Nichtüberlappungsbereich möglichst klein ist.

Die Erfindung wird nun anhand der Figuren der Zeichnung näher erläutert:
Fig.1 zeigt schematisch als Blockschaltbild einen bekannten Zweiphasentaktgenerator,
Fig.2 zeigt schematisch einige Zeitdiagramme zur Fig.1,
Fig.3 zeigt schematisch als Blockschaltbild einen Zweiphasentaktgenerator nach der Erfindung und
Fig.4 zeigt schematisch einige Zeitdiagramme zur Fig.3.

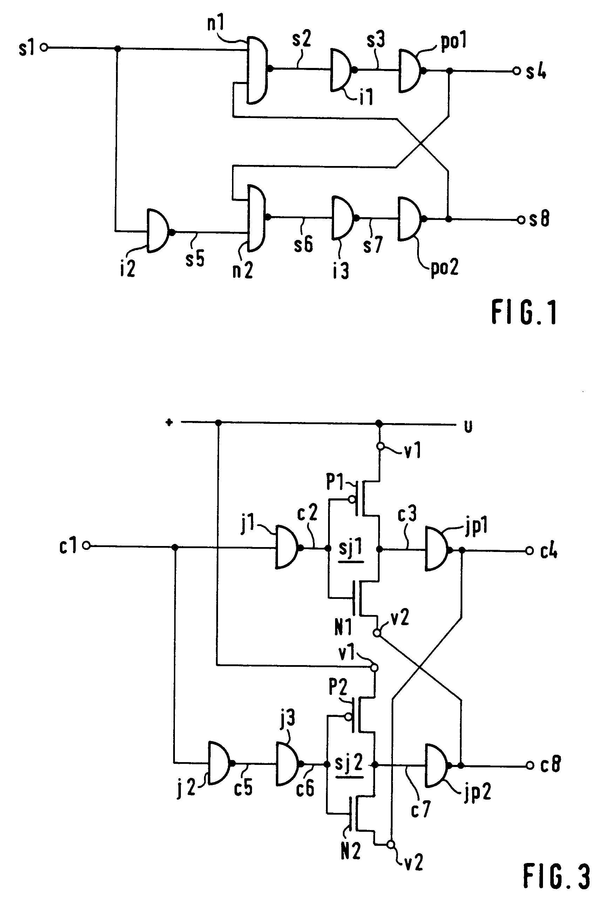

In dem bekannten Zweiphasentaktgenerator nach Fig.1 speist ein Eingangstakt s1 ein erstes Verknüpfungsgatter n1 mit angeschlossenem ersten Inverter i1, der von einem ersten Ausgangspuffer po1 gefolgt ist, an dessen Ausgang der erste Takt s4 abgreifbar ist. Parallel zu diesem ersten Signalpfad liegt der zweite Signalpfad, dessen Eingang ebenfalls vom Eingangstakt s1 gespeist ist, wobei der zweite Signalpfad in Signalflußrichtung aus einem zweiten Inverter i2, einem zweiten Verknüpfungsgatter n2, einem dritten Inverter i3 und einem zweiten Ausgangspuffer po2 besteht, an dessen Ausgang der nichtüberlappende zweite Takt s8 abgreifbar ist. Die Signalrückführung erfolgt vom Ausgang des ersten bzw. zweiten Ausgangspuffers po1, po2 jeweils auf den noch freien Eingang des zweiten bzw. ersten Verknüpfungsgatters n2, n1.

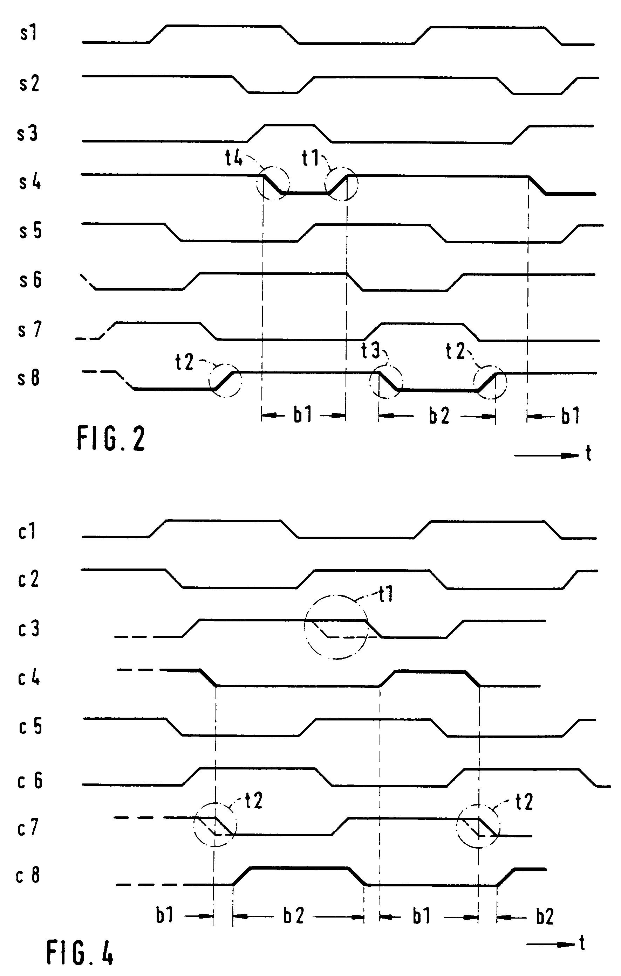

Zur Verdeutlichung sind alle auftretenden Signale in Fig.2 als Zeitdiagramme dargestellt. Die erste Zeile gibt den unipolaren Eingangstakt s1 wieder. In der zweiten Zeile befindet sich das Ausgangssignal s2 des ersten Verknüpfungsgatters n1, das ein NAND-Gatter ist. Die dritte Zeile zeigt das Ausgangssignal s3 des ersten Inverters i1. Schließlich zeigt die vierte Zeile den ersten Takt s4, nämlich Ausgangssignal des Ausgangspuffers po1, einem Inverter. In der fünften Zeile ist das Ausgangssignal s5 des zweiten Inverters i2 dargestellt, und die nächste Zeile zeigt das Ausgangssignal s6 des zweiten Verknüpfungsgatters n2, das aus einem NAND-Gatter besteht. Schließlich zeigt die siebte Zeile das Ausgangssignal s7 des dritten Inverters i3. Das um eine Gatterlaufzeit verzögerte Ausgangssignal des zweiten Ausgangspuffers po2, der ebenfalls ein Inverter ist, ist der zweite Takt s8 in der achten Zeile.

Der aktive Bereich des ersten Taktes s4 liegt im Zeitintervall b1 und der entsprechende aktive Bereich des zweiten Taktes s8 im Zeitintervall b2. Soll der aktive Bereich durch einen High-Pegel definiert werden, dann werden die beiden NAND-Gatter n1, n2 der Fig.1 durch jeweils ein NOR-Gatter ersetzt.

In Fig.2 zeigt der markierte Zeitpunkt t1 des ersten Taktes s4, daß erst dessen positive Anstiegsflanke das Abfallen des zweiten Taktes s8 zum Zeitpunkt t3 auslöst. Umgekehrt löst die positive Anstiegsflanke zum Zeitpunkt t2 des zweiten Taktes s8 erst die abfallende Flanke des ersten Taktes s4 zum Zeitpunkt t4 aus. Somit ergeben sich relativ große Nichtüberlappungsbereiche als Lücken zwischen den aktiven Zeitbereichen b1, b2.

In Fig.3 ist schematisch ein Blockschaltbild eines erfindungsgemäßen Zweiphasentaktgenerator dargestellt. Im ersten Signalpfad, der vom Eingangstakt c1 gespeist ist, liegt signalflußmäßig hintereinander ein erster Inverter j1, ein erster schwebender Inverter sj1 und ein Ausgangspuffer jp1. Im zweiten Signalpfad, der ebenfalls vom Eingangstakt c1 gespeist ist, liegt signalflußmäßig hintereinander ein zweiter und ein dritter Inverter j2, j3, ein zweiter schwebender Inverter sj2 und ein zweiter Ausgangspuffer jp2. Mittels der ersten drei Inverter j1, j2, j3 werden gegenphasige Ansteuersignale c2, c6 für die Eingänge der beiden schwebenden Inverter sj1, sj2 gebildet, deren erste Versorgungsanschlüsse v1 an eine feste Versorgungsspannung u angeschlossen sind. Die beiden zweiten Versorgungsanschlüsse v2 dienen jeweils als Einkoppelpunkt für die Signalrückführung, und zwar ist das Ausgangssignal des ersten Ausgangspuffers jp1, nämlich der erste Takt c4, auf den zweiten Versorgungsanschluß v2 des zweiten schwebenden Inverters sj2 geführt. Entsprechend ist das Ausgangssignal des zweiten Ausgangspuffers jp2, nämlich der zweite Takt c8 auf den zweiten Versorgungsanschluß v2 des ersten schwebenden Inverters sj1 geführt. Durch diese Maßnahme wird erreicht, daß die Ausgangssignale c3, c7 der beiden schwebenden Inverter erst dann auf einen niederen Pegel gehen können, wenn ihre jeweiligen zweite Versorgungsanschlüsse v2 auch auf diesem niederen Pegel liegen. Diese zwangsweise Verknüpfung bewirkt, daß niemals beide Ausgangssignale c3, c7 der beiden schwebenden Inverter sj1, sj2 gleichzeitig auf niederem Pegel sind. Liegen invertierende Ausgangspuffer jp1, jp2 vor, dann gilt für die Taktsignale c4, c8, daß sie nie gleichzeitig einen hohen Pegel einnehmen. Damit ist die Nichtüberlappung gewährleistet. Zur Laufzeit in jedem Signalpfad trägt lediglich der jeweilige Ausgangspuffer und der jeweilige schwebende Inverter bei.

Wenn das Ausgangssignal des Ausgangspuffers gegenüber dem Ausgangssignal des schwebenden Inverters nicht invertiert ist, dann wird die Signalrückführung auf den ersten Versorgungsanschluß v1 geführt und der zweite Versorgungsanschluß v2 wird in diesem Fall an die untere Versorgungsspannung angeschlossen.

Eine besonders vorteilhafte Ausführungsform der beiden schwebenden Inverter sj1, sj2 ergibt sich in CMOS-Technik mit jeweils einem CMOS-Inverter aus einem P- und einem N-Kanal-Transistor P1, N1; P2, N2. Dabei ist der Source Anschluß der beiden P-Kanal-Transistoren P1, P2 mit einer positiven Versorgungsspannung u gespeist. Der Source-Anschluß des N-Kanal-Transistors N1 im ersten schwebenden Inverter sj1 ist allein mit dem Ausgang des zweiten Puffer-Inverters jp2 verbunden und der Source-Anschluß des N-Kanal-Transistors N2 im zweiten schwebenden Inverter sj2 ist allein mit dem Ausgang des ersten Puffer-Inverters jp1 verbunden. Die zusammengeschalteten Drain-Anschlüsse des jeweiligen P- und N-Kanal Transistors P1, N1; P2, N2 bilden den Ausgang des jeweiligen schwebenden Inverters sj1, sj2.

In Fig.4 ist anhand von acht Zeitdiagrammen c1 bis c8 die Funktionsweise der Schaltungsanordnung nach Fig.3 dargestellt. Die erste Zeile zeigt den unipolaren Eingangstakt c1 mit einem Puls/Pausenverhältnis von 1:1. Unmittelbar an den Eingangstakt gekoppelt sind das Ausgangssignal c2 des ersten Inverters j1 und die Ausgangssignale c5, c6 des zweiten und des dritten Inverters j2, j3. Diese Ausgangssignale c5, c6 sind in der fünften bzw. sechsten Zeile dargestellt. Die Ausgangssignale c2, c6 des ersten und dritten Inverters j1, j3 sind die gegenphasigen Ansteuersignale für den ersten und zweiten schwebenden Inverter sj1, sj2. Das Ausgangssignal c3 des ersten schwebenden Inverters sj1 ist in der dritten Zeile dargestellt. Deren positive Flanke folgt um eine Gatterlaufzeit verzögert der negativen Flanke des c2-Signals. Im Zeitpunkt t1 ist als gestrichelte Linie dargestellt, wie die Abstiegsflanke des c3-Signals eigentlich der Anstiegsflanke des c2-Signals folgen müßte. Da der Fußpunkt v2 des ersten schwebenden Inverters sj1 zu diesem Zeitpunkt t1 jedoch noch einen H-Zustand aufweist (vgl. Zeitdiagramm c8), bleibt das c3-Signal noch so lange im H-Zustand, bis das c8-Signal ebenfalls in den L-Zustand am Ende des zweiten Zeitbereiches b2 übergegangen ist. Genau genommen findet der Übergang nahezu gleichzeitig mit dem Übergang des c8-Signals statt.

Ähnlich ist es beim zweiten schwebenden Inverter sj2, dessen Eingangssignal das c6-Signal ist und dessen Ausgangssignal das c7-Signal ist. Die Anstiegsflanke des c7-Signals folgt der Abstiegsflanke des c6-Signals um eine Gatterlaufzeit verzögert. Der Anstiegsflanke des c6-Signals müßte eigentlich eine Abstiegsflanke im c7-Signals folgen, die als gestrichelte Linie zum Zeitpunkt t2 im c7-Signal dargestellt ist. Da zu diesem Zeitpunkt der Fußpunkt v2 des Inverters noch nicht auf dem L-Potential liegt, weil sich das c4-Signal gerade in der Abwärtsflanke befindet, wird auch die Abwärtsflanke des c7-Signals zum Zeitpunkt t2 um ein geringen Wert verzögert. Der verzögerte Abfall des c7-Signals bewirkt, daß die Anstiegsflanke des c8-Signals, nämlich des zweiten Taktes, mindestens ebenfalls um diese Zeit verzögert wird.

Dadurch ergeben sich für den ersten bzw. zweiten Takt c4, c8 ein aktiver erster bzw. zweiter Zeitbereich b1, b2. In diesen beiden Zeitbereichen b1, b2 ist gewährleistet, daß keine Überlappung der H-Pegel der beiden Takte c4, c8 stattfindet. Die Nichtüberlappung der beiden Takte c4, c8 ist somit gesichert. Ein Vergleich der beiden Darstellungen nach Fig.2 und Fig.4 zeigt, daß die Nichtüberlappungsbereiche in Fig.4 deutlich kleiner sind.

In CMOS-Technik ist der Zweiphasentaktgenerator sehr einfach zu realisieren. Durch die Einbeziehung der beiden Ausgangspuffer jp1, jp2 in die Taktrückführung ist zudem sichergestellt, daß trotz der geringen Nichtüberlappungszeit die Nichtüberlappung der beiden Takte c4, c8 gewährleistet bleibt, auch wenn die von den Ausgangspuffern zu treibende Last sehr groß ist.

## Patentansprüche

1. Zweiphasentaktgenerator, der aus einem Eingangstakt durch Ausnutzung der Laufzeiten von Gattern einen ersten und einen nichtüberlappenden zweiten Takt erzeugt,
- mit einem ersten Verknüpfungsgatter und einem ersten Ausgangspuffer in einem ersten, den ersten Takt erzeugenden Signalpfad,
- mit einem zweiten Verknüpfungsgatter und einem zweiten Ausgangspuffer in einem zweiten, den zweiten Takt erzeugenden Signalpfad,
- mit einer Signalrückführung vom Ausgang des ersten bzw. zweiten Ausgangspuffers auf einen Einkoppelpunkt des zweiten bzw. ersten Verknüpfungsgatters und
- mit einer gegenphasigen Ankopplung von jeweils einem Eingang des ersten und des zweiten Verknüpfungsgatters an den Eingangstakt,
gekennzeichnet durch folgendes Merkmal:
als erstes bzw. zweites Verknüpfungsgatter dient ein erster bzw. ein zweiter schwebender Inverter (sj1, sj2), dessen erster Versorgungsanschluß (v1) an eine feste Versorgungsspannung (u) angeschlossen ist und dessen zweiter Versorgungsanschluß (v2) der Einkoppelpunkt für die jeweilige Signalrückführung ist.

2. Zweiphasentaktgenerator nach Anspruch 1, dadurch gekennzeichnet, daß der erste bzw. zweite Ausgangspuffer ein erster bzw. ein zweiter Pufferinverter (jp1, jp2) ist, dessen Eingang unmittelbar an den Ausgang des ersten bzw. zweiten schwebenden Inverters (sj1, sj2) angeschlossen ist.

3. Zweiphasentaktgenerator nach Anspruch 2, gekennzeichnet durch folgende Merkmale:
- der erste und zweite schwebende Inverter (sj1, sj2) ist jeweils ein CMOS-Inverter mit jeweils einem P- und einem N-Kanal-Transistor (P1, N1; P2, N2),
- der Source-Anschluß der beiden P-Kanal-Transistoren (P1, P2) ist mit einer positiven Versorgungsspannung (u) gespeist,
- der Source-Anschluß des N-Kanal-Transistors (N1) im ersten schwebenden Inverter (sj1) ist allein mit dem Ausgang des zweiten Puffer-Inverters (jp2) verbunden und
- der Source-Anschluß des N-Kanal-Transistors (N2) im zweiten schwebenden Inverter (sj2) ist allein mit dem Ausgang des ersten Puffer-Inverters (jp1) verbunden.

## Claims

1. A two-phase-clock generator which generates a first clock and a nonoverlapping second clock from an input clock by utilizing gates delays,
- with a first logic gate and a first output buffer in a first signal path generating the first clock,
- with a second logic gate and a second output buffer in a second signal path generating the second clock,
- with feedback from the outputs of the first and second output buffers to feed points of the second and first logic gates, respectively, and
- with one input of the first logic gate and one input of the second logic gate coupled to the input clock in phase opposition,
characterized by the following features:
The first and second logic gates are, respectively, a first floating inverter (sj1) and a second floating inverter (sj2) each having a first supply terminal (v1) and a second supply terminal (v2), said first supply terminal (v1) connected to a fixed supply voltage (u), and said second supply terminal (v2) being the feed point for the respective feedback signal.

2. A two-phase-clock generator as claimed in claim 1, characterized in that the first and second output buffers are a first buffer-inverter (jp1) and a second buffer-inverter (jp2) having their inputs connected directly to the outputs of the first and second floating inverters (sj1, sj2), respectively.

3. A two-phase-clock generator as claimed in claim 2, characterized by the following features:
- The first and second floating inverters (sj1, sj2) are CMOS inverters each consisting of a P-channel transistor (P1, P2) and an N-channel transistor (N1, N2);
- the source terminals of both P-channel transistors (P1, P2) are connected to a positive supply voltage (u);
- the source terminal of the N-channel transistor (N1) in the first floating inverter (sj1) is connected solely to the output of the second buffer-inverter (jp2), and
- the source terminal of the N-channel transistor (N2) in the second floating inverter (sj2) is connected solely to the output of the first buffer-inverter (jp1).

## Revendications

1. Générateur de cadence biphasé, qui, à partir d'une cadence d'entrée, produit une première cadence et une seconde cadence non en chevauchement, moyennant l'utilisation des temps de propagation dans des portes, comportant
- une première porte logique et un premier tampon de sortie situés dans une première voie de transmission de signaux, qui produit la première cadence,
- une seconde porte logique et un second tampon de sortie situés dans une seconde voie de transmission de signaux, qui produit la seconde cadence,
- un trajet de réaction du signal qui s'étend depuis la sortie du premier ou du second tampon de sortie jusqu'à un point de couplage de la seconde ou de la première porte combinatoire, et
- un couplage en opposition de phase d'une entrée respective des première et seconde portes logiques à la cadence d'entrée,
caractérisé par les caractéristiques suivantes :
comme première ou seconde porte logique on utilise un premier ou un second inverseur flottant (sj1, sj2), dont la première borne d'alimentation (v1) est placée à une tension d'alimentation fixe (u) et dont la seconde borne d'alimentation (v2) est le point de couplage pour le trajet respecitf de réaction du signal.

2. Générateur de cadence biphasé selon la revendication 1, caractérisé en ce que le premier ou le second tampon de sortie est constitué par un premier ou un second inverseur tampon (jp1, jp2), dont l'entrée est reliée directement à la sortie du premier ou du second inverseur flottant (sj1, sj2).

3. Générateur de cadence biphasé selon la revendication 2, caractérisé par les caractéristiques suivantes :
- les premier et second inverseurs flottants (sj1, sj2) sont constitutés respectivement par un inverseur CMOS comportant respectivement un transistor à canal P et un transistor à canal N (P1, N1; P2, N2),
- la borne de source des deux transistors à canal P (P1, P2) est alimentée par une tension d'alimentation positive (u),
- la borne de source du transistor à canal N (N1) dans le premier inverseur flottant (sj1) est reliée uniquement à la sortie du second inverseur tampon (jp2), et
- la borne de source du transistor à canal N (N2) dans le second inverseur flottant (sj2) est reliée uniquement à la sortie du premier inverseur tampon (jp1).
